(19) **Europäisches Patentamt**

**European Patent Office**

**Office européen des brevets**

(11) Numéro de publication : **0 155 731**
**B1**

(12) **FASCICULE DE BREVET EUROPÉEN**

(45) Date de publication du fascicule du brevet :
**01.02.89**

(21) Numéro de dépôt : **85200354.0**

(22) Date de dépôt : **11.03.85**

(51) Int. Cl.⁴ : **G 11 C 8/00, G 06 F 9/30**

(54) **Dispositif d'adressage pour fournir à une mémoire des codes d'adresse.**

(30) Priorité : **13.03.84 FR 8403813**

(43) Date de publication de la demande :
**25.09.85 Bulletin 85/39**

(45) Mention de la délivrance du brevet :
**01.02.89 Bulletin 89/05**

(84) Etats contractants désignés :
**DE FR GB**

(56) Documents cités :
**GB—A— 2 016 753**
**US—A— 3 602 901**
**US—A— 4 125 870**
**US—A— 4 280 199**

(73) Titulaire : **TELECOMMUNICATIONS RADIOELECTRI-QUES ET TELEPHONIQUES T.R.T.**
**88, rue Brillat Savarin**
**F-75013 Paris (FR)**

(72) Inventeur : **Barazesh, Bahman**
**SOCIETE CIVILE S.P.I.D. 209 rue de l'Université**
**F-75007 Paris (FR)**
Inventeur : **Mary, Luc**
**SOCIETE CIVILE S.P.I.D. 209 rue de l'Université**
**F-75007 Paris (FR)**

(74) Mandataire : **Chaffraix, Jean et al**
**Société Civile S.P.I.D. 209, rue de l'Université**
**F-75007 Paris (FR)**

**Description**

La présente invention concerne un dispositif d'adressage pour fournir à une mémoire des codes d'adresse provenant d'un registre principal à contenu variable auquel sont associés d'une part un circuit d'incrémentation pour faire évoluer le contenu du registre principal et d'autre part un circuit de chargement, dispositif comportant deux registres auxiliaires l'un pour contenir la valeur minimum que peut atteindre le contenu du registre principal et l'autre pour contenir la valeur maximum que peut atteindre le contenu du registre principal et aussi un circuit de comparaison pour tester le contenu du registre principal.

Un tel dispositif trouve des applications importantes notamment lorsqu'on veut remplir les fonctions d'un filtre transversal fixe ou adaptatif en transmission de données. La mémoire contient sous forme numérique à des adresses successives différents échantillons du signal à filtrer et pour traiter le signal il importe d'adresser cycliquement les emplacements de la mémoire contenant ces échantillons de façon à simuler un registre à décalage dans la mémoire qui est du type mémoire vive.

Un tel dispositif est décrit dans l'article intitulé « An LSI Signal Processor» de M. Yano, K. Inoue et T. Senba paru dans le volume 2 IEE INTERNATIONAL CONFERENCE ON ACOUSTICS, SPEECH AND SIGNAL PROCESSING, Conférence des 3, 4, 5 mai 1982 tenue à Paris, France.

Dans ce dispositif connu le circuit de comparaison compare le contenu du registre principal avec celui du registre auxiliaire contenant la valeur maximum, On est alors contraint pratiquement de faire évoluer le contenu du registre principal toujours dans le même sens.

La présente invention propose un dispositif d'adressage mentionné dans le préambule qui permet une évolution du registre principal dans les deux sens.

Pour cela, il est remarquable en ce que le circuit de chargement coopérant avec le circuit de comparaison est prévu pour charger le registre principal avec la valeur minimum lorsqu'il contient la valeur maximum et avec la valeur maximum lorsqu'il contient la valeur minimum.

Un avantage important de l'invention est que le dispositif d'adressage devient particulièrement bien adapté pour fonctionner avec des processeurs travaillant selon le mode « pipe-line ». En effet dans ce mode de travail les résultats d'opération arrivent avec un retart dû au « pipe-line ». L'utilisation du mode « pipe-line » dans les algorithmes de filtrage nécessite de réaliser deux opérations différentes sur la même donnée à deux instants diférents, ce qui entraîne que l'on doit incrémenter et décrémenter à volonté le registre principal, ce que permet la présente invention même au voisinage des valeurs maximum et minimum des codes d'adresse.

Une caractéristique importante de l'invention selon laquelle le dispositif d'adressage prévu pour coopérer avec un système à microprocesseur comportant une ligne de bus d'instructions et une ligne de bus de données est pourvu de moyens de connexion entre la sortie du registre principal et le bus de données afin de sauvegarder dans la mémoire du système à microprocesseur le contenu du registre principal, permet de réaliser les fonctions de plusieurs filtres transversaux indépendants au moyen du même système.

La description suivante faite en regard des dessins annexés, le tout donné à titre d'exemple non limitatif fera bien comprendre comment l'invention peut être réalisée.

La figure 1 représente un dispositif d'adressage conforme à l'invention.

La figure 2 représente le format de quelques instructions faisant fonctionner le dispositif d'adressage de la figure.

La figure 3 est un diagramme temps utilisé pour expliquer le fonctionnement du dispositif d'adressage de la figure 1.

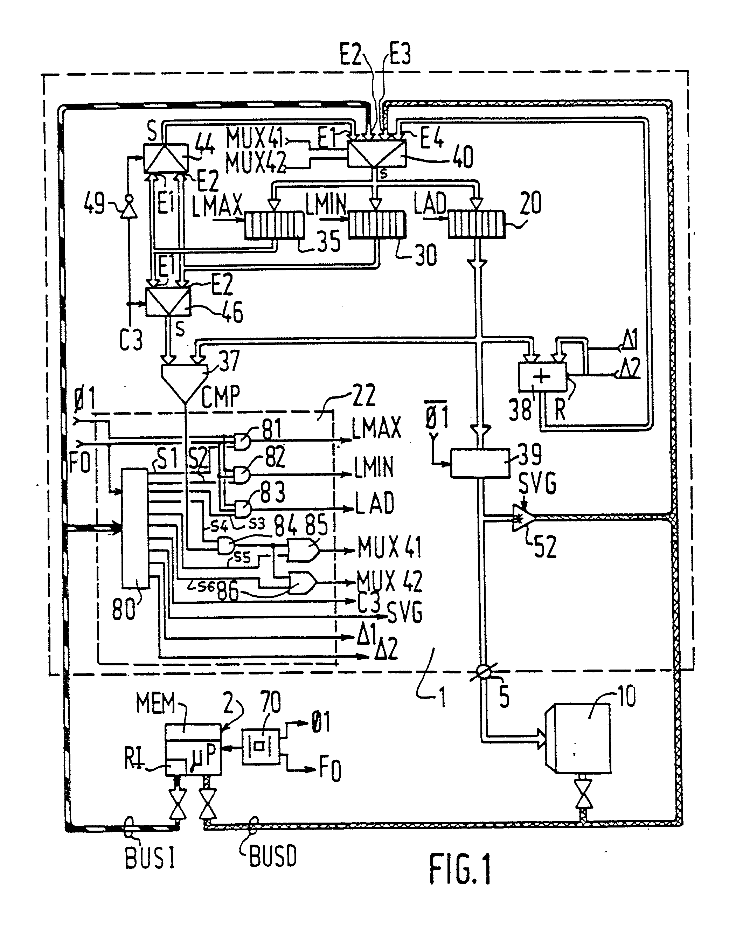

Le dispositif d'adressage 1 montré à la figure 1 est destiné à coopérer avec un système à microprocesseur 2. Ce système opère selon des instructions véhiculées par une ligne bus BUSI, issues d'un registre RI ; des données, résultats de calculs effectués par le système 2 apparaissent sur une ligne bus BUSD. Le dispositif d'adressage 1 fournit sur sa sortie 5 un code d'adresse pour une mémoire 10. Ce code provient d'un registre 20 dit registre principal dont le contenu est susceptible d'évoluer sous la commande d'un circuit de chargement 22. A cet effet la commande de chargement du registre 20 est reliée au circuit 22 par l'intermédiaire d'un fil LAD.

Le dispositif d'adressage 1 comporte deux registres auxiliaires, l'un portant la référence 30 pour contenir la valeur minimum à partir de laquelle le contenu du registre principal est susceptible d'évoluer et l'autre portant la référence 35 pour contenir la valeur maximum que peut atteindre le registre principal. Il est prévu aussi un circuit de comparaison 37 coopérant avec le circuit de chargement 22. Une entrée de ce circuit 37 est connectée aux sorties en parallèle du registre 20. Un circuit d'incrémentation constitué essentiellement par un additionneur 38 est utilisé pour faire varier de $\pm \Delta$ la valeur contenue dans le registre 20. Un registre 39 de type registre « LATCH » sert d'interface entre les sorties du registre 20 et la sortie 5 reliée à l'entrée pour code d'adresse de la mémoire 10. Ce registre 39 est mis à l'état passant par la valeur « 0 » d'un signal $\phi 1$.

Conformément à l'invention, le circuit de chargement 22 coopérant avec le circuit de comparaison 37 est prévu pour charger le registre principal 20 avec la valeur minimum (contenue dans le registre 30) lorsqu'il contient la valeur maximum et avec la valeur maximum (contenue dans le registre 35) lorsqu'il contient la valeur minimum.

Les opérations de chargement et d'incrémentation s'effectuent par l'intermédiaire d'un premier multiplexeur 40 muni de quatre entrées E1, E2, E3 et E4. L'entrée E1 est reliée à la sortie S d'un multiplexeur 44 à deux entrées, l'entrée E2 à la ligne BUSI, l'entrée E3 au bus BUSD et l'entrée E4 à la sortie du circuit additionneur 38. La connexion entre une de ces entrées E1 à E4 et la sortie S du multiplexeur 40 est déterminée par deux commandes MUX 41, MUX 42. Les entrées E1 et E2 du multiplexeur 44 sont communes avec les entrées E1 et E2 d'un autre multiplexeur 46. Les entrées E1 de 44 et 46 sont reliées aux sorties en parallèle du registre 35 et les entrées E2, de 44 et 46 aux sorties du registre 30. Les entrées en parallèle des registres 20, 30 et 35 sont toutes reliées à la sortie S du multiplexeur 40. Les multiplexeurs 44 et 46 sont commandés par un signal C3 pour le multiplexeur 46 et par le signal $\overline{C3}$ obtenu par l'inverseur de signaux logiques 49. Ainsi pour une valeur de C3 on a une connexion entre l'entrée E1 et la sortie S du multiplexeur 46 alors qu'une connexion entre l'entrée E2 et la sortie S du multiplexeur 44 est effectuée pour l'autre valeur de C3.

Les sorties en parallèle du registre 20 sont reliées comme il l'a été dit à une première entrée du comparateur 37 dont la deuxième entrée est reliée à la sortie S du multiplexeur 46.

L'invention fournit donc les moyens pour adresser cycliquement des adresses c'est-à-dire que par de simples instructions d'incrémentation Δ de pointeur de mémoires on passe de la valeur d'adresse maximum ADM à la valeur d'adresse minimum ADm soit séquentiellement : ADm, ADm + Δ, ... ADM — Δ, ADM, ADm + Δ... ou de la valeur d'adresse minimum ADm à la valeur d'adresse maximum ADM soit séquentiellement : ADM, ADM — Δ, ... ADm + Δ, ADm, ADM, ADM — Δ, Δ peut avoir les valeurs typiques : 0, 1...

Le circuit additionneur 38 dont les opérandes sont, par exemple définis par 7 bits est muni d'une entrée pour retenue « R ». Une valeur $\Delta_2$ est appliquée à « R » et aux six entrées de poids fort pour un opérande et la septième entrée est reliée à la valeur $\Delta_1$, alors que les sept entrées de l'autre opérande sont reliées aux sorties parallèles du registre 20.

Les sorties en parallèle du registre 20 sont aussi reliées au bus BUSD par l'intermédiaire d'un ensemble 52 d'amplificateurs à trois états munis d'une commande SVG. Ainsi le contenu du registre 20 peut être sauvegardé dans un emplacement d'une mémoire MEM faisant partie du microprocesseur 2. Cette sauvegarde offre la possibilité d'effectuer plusieurs traitements indépendants. Dans l'application envisagée, on peut remplir les fonctions de plusieurs filtres transversaux.

Une horloge 70 fournit les signaux qui règlent la vitesse d'exécution du système 2. De cette horloge 70, on dérive deux signaux périodiques, le signal φ1 qui détermine la cadence d'apparition des instructions sur la ligne BUSI et un signal FO de fréquence double du précédent. Ces signaux sont utilisés par le circuit de chargement 22. Le circuit de chargement 22 est formé par un réseau de logique programmé 80 qui, à partir des informations véhiculées par la ligne BUSI et le signal FO, fournit les signaux S1 à S6, C3, SVG, Δ1 et Δ2. Trois portes « ET » 81, 82 et 83 fournissent les commandes de chargement LMAX, LMIN et LAD pour les registres 35, 30 et 20. Deux des trois entrées de ces portes reçoivent les signaux φ1 et FO alors que la troisième entrée de ces portes 81, 82 et 83 reçoivent respectivement les signaux S1, S2 et S3. Une quatrième porte ET 84 reçoit sur une de ses entrées le signal S4 et sur l'autre le signal CMP apparaissant à la sortie du comparateur 37. Deux portes « OU » 85 et 86 fournissent les codes MUX 41 et MUX 42 ; une entrée de ces portes est connectée à la sortie de la porte 84 ; l'autre entrée de ces portes 85 et 86 reçoit respectivement le signal S5 et le signal S6.

Le réseau 80 est programmé de façon à ce que les équations logiques ci-dessous soient réalisées.

$S_1 = I_0 \cdot I_1 \cdot I_2 \cdot \overline{I_3} \cdot \overline{I_4}$

$S_2 = I_0 \cdot I_1 \cdot I_2 \cdot I_3 \cdot I_4$

$S_3 = I_0 \cdot \overline{I_1} \cdot \overline{I_2} \cdot I_{28} \cdot I_{29} \cdot I_{31} + \overline{I_0} \cdot \overline{I_1} \cdot I_3$

$S_4 = \overline{I_0} \cdot \overline{I_1} \cdot I_3 \cdot I_{25}$

$S_5 = I_0 \cdot I_1 \cdot I_2 + \overline{I_0} \cdot \overline{I_1}$

$S_6 = I_0 \cdot I_1 + \overline{I_0} \cdot \overline{I_1}$

$C_3 = \overline{I_0} \cdot \overline{I_1} \cdot I_{24}$

$SVG = (I_0 \cdot \overline{I_1} \cdot I_2 \cdot \overline{I_3} \cdot \overline{I_4} \cdot I_5 \cdot \overline{I_6} \cdot I_8 \cdot I_9) \cdot \phi1$

$\Delta_1 = I_0 \cdot I_1 \cdot I_{25} \cdot \overline{I_{24}} + I_0 \cdot I_1 \cdot \overline{I_{25}} \cdot I_{24}$

$\Delta_2 = I_0 \cdot I_1 \cdot I_{24}$

Dans ces équations le symbole « · » signifie l'opération ET logique tandis que le symbole « + » signifie l'opération OU logique. Les variables $I_i$ représentent les valeurs des éléments binaires transmis par la ligne BUSI.

Pour fixer les idées le tableau I ci-dessous donne les connexions établies par les multiplexeurs 44 et 46 en fonction de la valeur de $C_3$ et le tableau II donne en fonction des codes MUX 41 et MUX 42 les connexions établies par le multiplexeur 40.

Tableau I

| $C_3$ | Connexions Multiplexeur 46 | Connexions Multiplexeur 44 |
|---|---|---|
| 0 | $E_1 - S$ | $E_2 - S$ |
| 1 | $E_2 - S$ | $E_1 - S$ |

3

Tableau II

| MUX 41 | MUX 42 | Connexion |
|--------|--------|-----------|
| 0 | 0 | E1-S |
| 0 | 1 | E2-S |
| 1 | 0 | E3-S |
| 1 | 1 | E4-S |

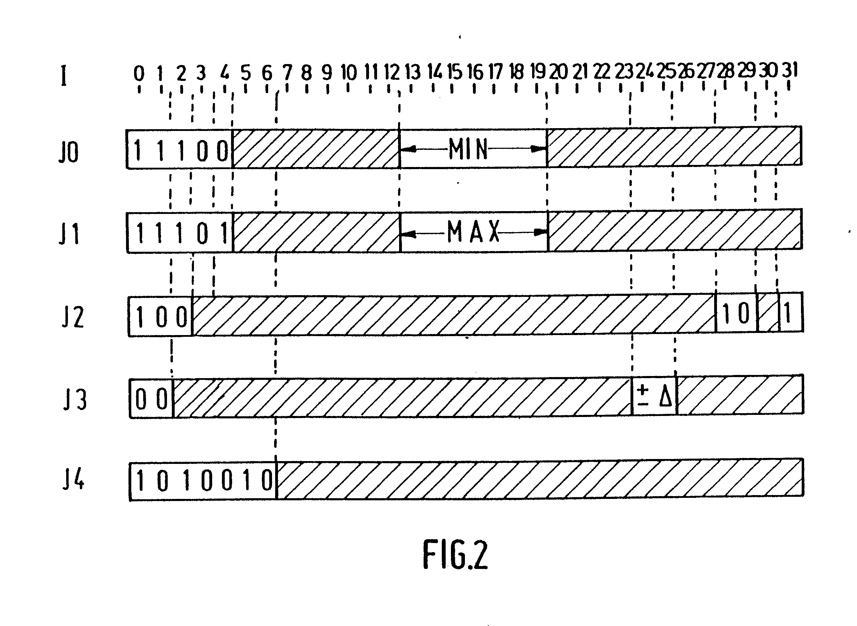

Afin d'expliquer le fonctionnement du dispositif d'adressage conforme à l'invention on fera appel à différentes instructions J0, J1, J2, J3 et J4 dont la structure est montrée à la figure 2. Toutes les instructions dont il sera question, sont formées de trente deux éléments binaires repérés par $I_0$ à $I_{31}$.

Pour initialiser le dispositif d'adressage 1, il faut utiliser des instructions J0 et J1 qui se caractérisent pour J0 par $I_0 = I_1 = I_2 = 1\ I_3 = I_4 = 0$ et pour J1, par $I_0 = I_1, = I_2 = 1\ I_3 = 0\ I_4 = 1$. Les instructions J0 et J1 permettent de charger les registres 30 et 35 respectivement par les valeurs « MIN » et « MAX » déterminées au moyen des éléments binaires $I_{13}$ à $I_{19}$.

Pour charger le registre 20 on utilise l'instruction J2 qui est caractérisée par $I_0 = 1\ I_1 = I_2 = 0\ I_{28} = 1$ $I_{29} = 0$ et $I_{31} = 1$.

La valeur chargée dans le registre 20 arrive par le bus BUSD et au début de traitement peut être n'importe quelle valeur comprise entre ADMIN et ADMAX.

Dans le cas où le même système est appelé à réaliser en temps partagé les fonctions de plusieurs filtres transversaux, pour chaque filtre la valeur du registre 20 est rappelée de la mémoire MEM du microprocesseur et à la fin du traitement on mémorise le contenu du registre 20 dans la mémoire pour la période suivante.

L'instruction J3 apporte des valeurs d'incrément $\Delta$ dont la valeur est déterminée par l'élément binaire $I_{25}$ et dont le signe positif ou négatif est fourni par la valeur de l'élément binaire $I_{24}$. L'instruction J4 est utilisée pour la sauvegarde du contenu du registre 20 dans la mémoire MEM. Les instructions J3 et J4 sont caractérisées par $I_0$ et $I_1$ égaux à « 0 » pour J3 et $I_0 = 1\ I_1 = 0\ I_2 = 1\ I_3 = I_4 = 0\ I_5 = 1\ I_6 = 0$ pour J4.

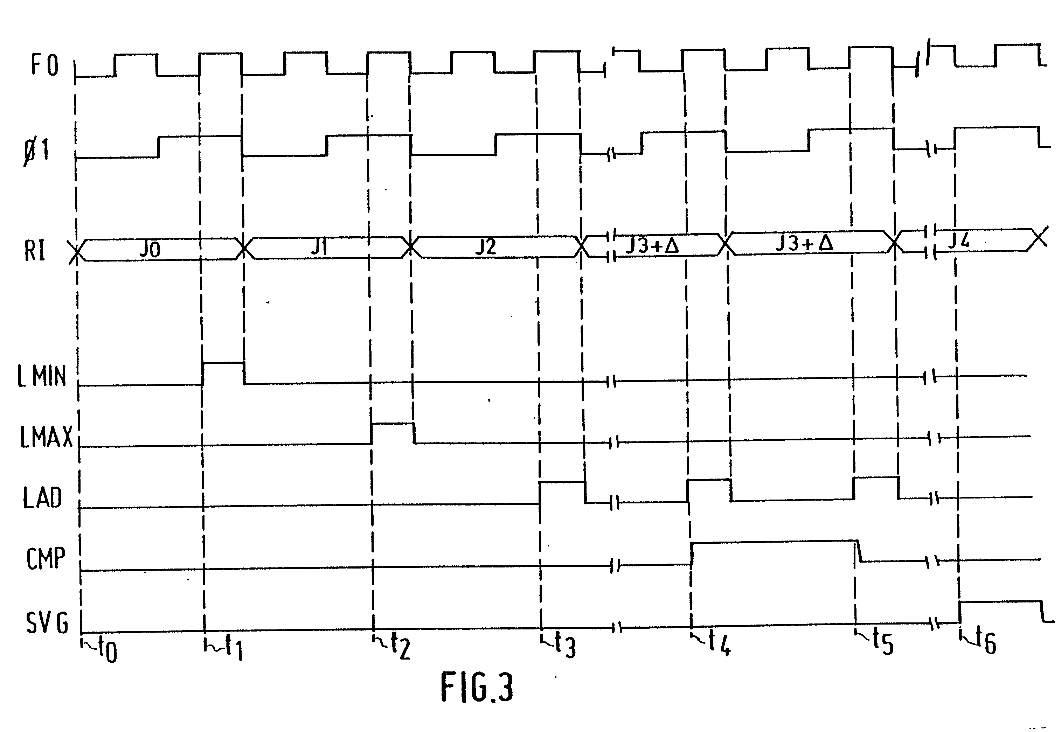

On peut maintenant expliquer le fonctionnement du dispositif d'adressage à l'aide du diagramme-temps de la figure 3.

Les instructions J0, J1, J2 ... J3 ... J4 arrivent dans le registre RI peu de temps après le front descendant du signal $\phi 1$.

A l'instant $t_0$, l'instruction J0 est décodée et les signaux MUX 41, MUX 42 prennent une valeur telle que la connexion $E_2 - S$ est établie à l'intérieur du multiplexeur 40 et à l'instant $t_1$, le registre 30 est chargé par les informations de sortie du multiplexeur 40.

Au cycle suivant, l'instruction J1 est décodée et la position du multiplexeur 40 reste sur $E_2 - S$. Puis, à l'instant $t_2$ le registre 35 est chargé par la valeur maximum que peut atteindre le registre 20. C'est au cycle suivant que la connexion $E_3 - S$ est établie par le multiplexeur 40, provoquée par le décodage de l'instruction J2. A l'instant $t_3$ le registre 20 est chargé par les informations de sortie du multiplexeur 40.

Le dispositif d'adressage est initialisé pour fournir des adresses à partir de $t_3$.

Le décodage de l'instruction J3 provoque l'établissement d'un code MUX 41 et MUX 42 tel que la connexion $E_4 - S$ est établie. Dans l'exemple décrit on admet que le registre 20 s'incrémente par valeurs positives. Après un certain nombre de pas d'incrémentation, à l'instant $t_4$ le registre 20 contient une valeur égale à la valeur contenue dans le registre 35 et le signal CMP prend la valeur 1. A l'instruction suivante on suppose que l'incrémentation demandée est toujours positive. Cette condition, compte tenu de la valeur « 1 » du signal CMP, provoque, à l'instant $t_5$, le chargement du registre 20 par la valeur contenue dans le registre 30. Pour cela le multiplexeur 40 effectue la connexion $E_1 - S$ et le multiplexeur 44 $E_2 - S$, alors que la connexion $E_1 - S$ est effectuée à l'intérieur du multiplexeur 46.

Lorsque l'on veut réaliser les fonctions d'un autre filtre il faut sauvegarder le contenu du registre 20, comme il a été déjà dit, dans la mémoire du microprocesseur 2. A cette fin on fait appel à l'instruction J4 qui, décodée, provoque la valeur 1 du signal SVG à l'instant $t_6$ ; les sorties du registre 20 sont mises en relation avec le bus BUSD par l'intermédiaire du registre 39 et l'ensemble 52.

**Revendications**

1. Dispositif d'adressage pour fournir à une mémoire des codes d'adresse provenant d'un registre principal à contenu variable auquel sont associés d'une part un circuit d'incrémentation pour faire évoluer le contenu du registre principal et d'autre part un circuit de chargement, dispositif comportant deux registres auxiliaires l'un pour contenir la valeur minimum que peut atteindre le contenu du registre principal et l'autre pour contenir la valeur maximum que peut atteindre le contenu du registre principal et aussi un circuit de comparaison pour tester le contenu du registre principal, caractérisé en ce que le circuit de chargement coopérant avec le circuit de comparaison est prévu pour charger le registre principal avec la valeur minimum lorsqu'il contient la valeur maximum et avec la valeur maximum lorsqu'il contient la valeur minimum.

2. Dispositif d'adressage selon la revendication 1 prévu pour coopérer avec un système à microprocesseur comportant une ligne de bus d'instructions et une ligne de bus de données, caractérisé en ce qu'il comporte un circuit pour charger lesdits registres auxiliaires à partir du bus d'instructions et le registre principal à partir du bus de données.

3. Dispositif d'adressage selon la revendication 2, caractérisé en ce qu'il est pourvu de moyens de connexion entre la sortie du registre principal et le bus de données afin de sauvegarder dans la mémoire du système à microprocesseur le contenu du registre principal.

## Claims

1. An addressing device for supplying a memory with address codes originating from a variable-contents principal register whereto there are connected an incrementation circuit for modifying the contents of the principal register as well as a loading circuit, which device comprises two auxiliary registers, one of which serves to store the minimum value to be reached by the contents of the principal register while the other auxiliary register serves to store the maximum value to be reached by the contents of the principal register, and also comprises a comparison circuit for testing the contents of the principal register, characterized in that the loading circuit which cooperates with the comparison circuit serves to load the principal register with the minimum value when it contains the maximum value and with the maximum value when it contains the minimum value.

2. An addressing device as claimed in Claim 1 intended for cooperation with a microprocessor system comprising an instruction bus line and a data bus line, characterized in that it comprises a circuit for loading said auxiliary registers from the instruction bus and for loading the principal register from the data bus.

3. An addressing device as claimed in Claim 2, characterized in that it comprises connection means which are provided between the output of the principal register and the data bus in order to save the contents of the principal register in the memory of the microprocessor system.

## Patentansprüche

1. Adressieranordnung zum Ausgeben von Adreßcodes an einen Speicher, mit einem Hauptregister mit veränderlichem Inhalt, dem einerseits eine Inkrementschaltung zum Beinflussen des Inhalts des Hauptregisters und andererseits eine Ladungsschaltung zugeordnet sind, wobei die Adressieranordnung zwei Hilfsregister, von denen eines zum Aufnehmen des Mindestwertes, den der Inhalt des Hauptregisters erreichen kann, und das andere zum Aufnehmen des Höchstwertes dienen, den der Inhalt des Hauptregisters erreichen kann, und weiter eine Komparatorschaltung zum Überprüfen des Inhalts des Hauptregisters enthält, dadurch gekennzeichnet, daß die Ladungsschaltung mit der Komparatorschaltung zusammenarbeitet, und zum Laden des Hauptregisters mit dem Mindestwert, wenn es den Höchstwert enthält, und mit dem Höchstwert dient, wenn es den Mindestwert enthält.

2. Adressieranordnung nach Anspruch 1 zum Zusammenarbeiten mit einem Mikroprozessorsystem, das eine Befehlsbusleitung und eine Datenbusleitung enthält, dadurch gekennzeichnet, daß die Anordnung eine Ladungsschaltung zum Laden der Hilfsregister durch den Befehlsbus und zum Laden des Hauptregisters durch den Datenbus enthält.

3. Adressieranordnung nach Anspruch 2, dadurch gekennzeichnet, daß die Anordnung Verbindungsmittel zwischen dem Ausgang des Hauptregisters und dem Datenbus enthält, um im Speicher des Mikroprozessorsystems den Inhalt des Hauptregisters zwischenzuspeichern.

FIG.1

FIG.2

FIG.3

EP 0 155 731 B1